Europäisches Patentamt

European Patent Office

Office européen des brevets

(19)

(11) EP 0 528 565 B1

(12) EUROPEAN PATENT SPECIFICATION

(45) Date of publication and mention
of the grant of the patent:
05.06.1996 Bulletin 1996/23

(51) Int Cl.⁶: $G06F\ 1/03$, $H03B\ 23/00$

(21) Application number: 92306939.7

(22) Date of filing: 30.07.1992

(54) **Digital chirp generator systems**

Digitale Wobleroszillatorsysteme

Générateurs numériques de balayage en fréquence

(84) Designated Contracting States:
DE FR GB IT

(30) Priority: 14.08.1991 GB 9117533

(43) Date of publication of application:
24.02.1993 Bulletin 1993/08

(73) Proprietor: MATRA MARCONI SPACE UK LIMITED
Stanmore Middlesex HA7 4LY (GB)

(72) Inventor: Parkes, Stephen Maxwell,
c/o British Aerospace
Filton, Bristol BS12 7QW (GB)

(74) Representative: Waters, Jeffrey et al
The General Electric Company, p.l.c.
GEC Patent Department
Waterhouse Lane
Chelmsford, Essex CM1 2QX (GB)

(56) References cited:
EP-A- 0 078 588          US-A- 4 783 632

• MARCONI INSTRUMENTATION vol. 16, no. 4,
1979, ST ALBANS GB pages 87 - 90 SHIELD
'Multiband to 18 GHz'

## Description

This invention relates to digital chirp generator systems.

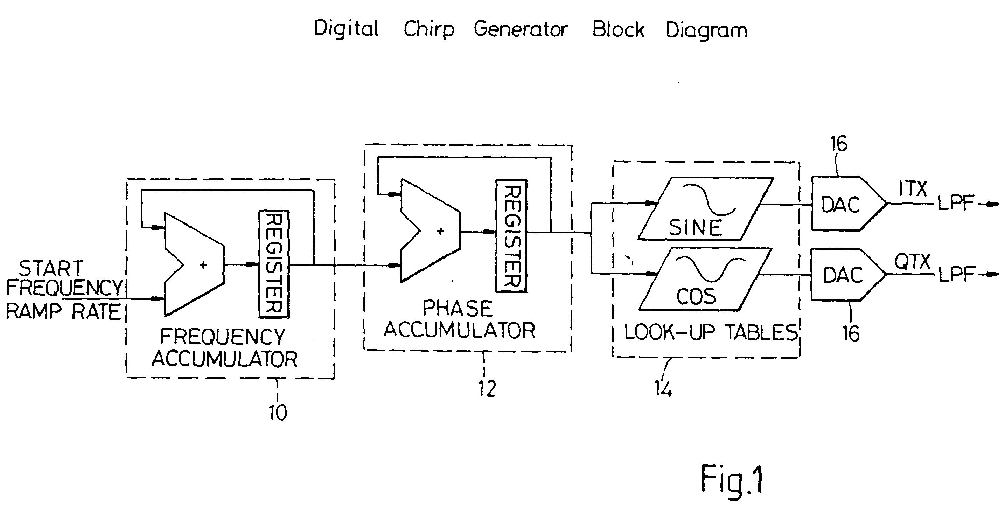

Digital chirp generation is a well known technique for generating linear frequency modulated (LFM) signals widely used in radar and sonar applications. A conventional digital chirp generator is shown in Figure 1 of the accompanying drawings. It comprises a frequency accumulator 10, a phase accumulator 12, sine/cosine look-up tables 14 and digital to analogue converters (DACs)16. The frequency and phase accumulators 10 and 12 are n-bit accumulators. Such generators have limited performance in terms of bandwidth/clock speed and it is an aim of this invention to provide a digital chirp generator in which the performance is improved.

EP-A-0078588 discloses a digital signal generator which comprises a plurality of sine generators in parallel whose outputs are selected in sequence and interleaved to produce a composite signal representing the waveform being synthesized. Frequency and phase modulation of the synthesized waveform may be implemented by adding the modulation information prior to selectively coupling the outputs, but there is no reference to generation of linear frequency modulated signals.

According to this invention, there is provided a digital chirp generator system including:-

a plurality of digital chirp generator elements each comprising a frequency accumulator including an input port and an output port, a multiplier or shifter including an input port coupled to the output port of the frequency accumulator and an output port coupled to an input port of a phase accumulator, each of said digital chirp generator elements being operable to produce at the respective output ports of said phase accumulators a plurality of phase samples, and means for interleaving said phase samples with phase samples from the or each other digital chirp generator elements to provide a sequence of phase samples representing a chirp signal.

The invention may be performed in various ways and an embodiment thereof with certain variations will now be described by way of example only, reference being made to the accompanying drawings, in which:-

Figure 1 is a block diagram of a conventional digital chirp generator;
Figure 2 is an overall schematic diagram of an embodiment of parallel digital chirp generator system in accordance with the invention;
Figure 3 is a block diagram of a digital chirp generator element for use in the system of figure 2;
Figure 4 is a block diagram of a 4-element parallel digital chirp generator in accordance with the invention, and
Figure 5 is a view of a digital chirp generator element for use in an alternative initialisation routine.

The digital chirp generator system preferably includes an interleaving circuit, sine/cosine look-up tables and digital to analogue converters. The interleaving circuit may be located at various stages. It may be located before the sine/cosine look-up tables, or after the sine/cosine look-up tables and prior to the digital to analogue converters, or after the digital to analogue converters, or it may be distributed, partly prior to the sine/cosine look-up tables, partly prior to the digital to analogue converters and partly after the digital to analogue converters.

The digital chirp generator system preferably includes means for supplying to an input port of the frequency accumulator an increment value **m.r,** and means for supplying to an input port of said phase accumulator a value **(m-1). m.r/2,** and said multiplier or shifter preferably multiplies the value presented to the input port of the multiplier or shifter by **m,** wherein **m** is the number of digital chirp generator elements in said plurality and r is the ramp rate or frequency increment.

The digital chirp generator preferably includes means for initialising the phase and frequency accumulators with appropriate values.

The digital chirp generator may be placed in an initialisation configuration, and include means for loading the phase and frequency accumulators of the digital chirp generator elements with an initial value, and means for then selectively clocking said accumulators to provide the required start frequency and start phase values for each digital chirp element.

Said initialisation values may comprise, for the $\mathbf{k}^{th}$ digital chirp generator element, a value of $\mathbf{f+(k-1)r}$ for the frequency accumulator and a value of $\mathbf{p+(k-1)f+(k-1)(k-2)r/2}$ for the phase accumulator, wherein **p** and **f** are the initial phase and frequency values respectively, and **r** is the ramp rate or frequency increment.

The illustrated embodiment has several digital chirp generator circuits which operate together in parallel. The outputs of the digital chirp generators are interleaved to provide a chirp signal which has an improved bandwidth compared to the chirp signal from a single digital chirp generator. Hereinafter each of the digital chirp generators will be referred to as a digital chirp generator element and the entire system will be referred to as a parallel digital chirp generator.

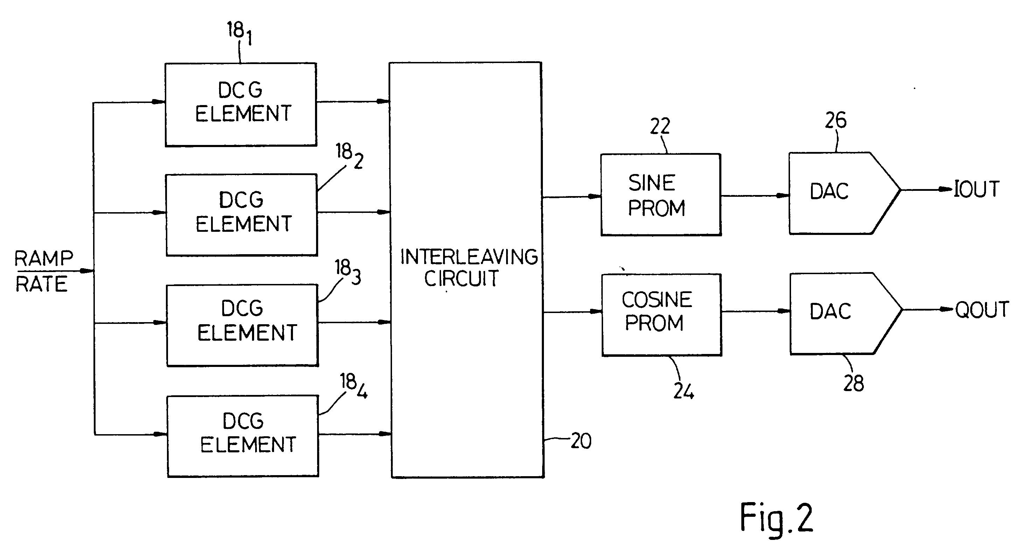

Such a parallel digital chirp generator is shown in Figure 2. It comprises several digital chirp generator elements, in this example four such elements $18_1$ to $18_4$, an interleaving circuit 20, sine/cosine look-up tables 22, 24 and a pair of digital to analogue converters (DACs) 26, 28. A master clock signal (not shown) drives all the digital chirp generator elements $18_1$ to $18_4$ so that they all produce their output signals at the same time. In this example the outputs of the parallel digital chirp generator elements are interleaved before the sine/cosine look-up tables.

The first digital chirp generator element $18_1$ will produce the first output sample, the second digital chirp generator element $18_2$ the second sample, and so on with the mth digital chirp generator element producing the mth sample. All these outputs will be available simultaneously at the outputs of the m digital chirp generator elements. At time T these signals are transferred in parallel to the interleaving circuit 20.

At time 2T the output samples m+1, m+2,......, 2m will be produced by the digital chirp generator elements and transferred to the interleaving circuit 20. In general at time NT the digital chirp generator elements $18_1$ to $18_4$ will produce samples (N-1)m+1, (N-1)m+2,....Nm-1,Nm.

The interleaving circuit 20 takes all m digital phase values from the m digital chirp generator elements $18_1$ to $18_4$ in parallel and passes them one by one in the correct sequence to the sine/cosine look-up tables 22, 24 and DACs 26, 28.

An alternative implementation could place the interleaving circuit after the DACs. Then the interleaving circuit would take the form of a series of analogue switches which are activated one at a time to interleave the signals from several DACs into a single high-bandwidth analogue signal. Furthermore the interleaving function may be distributed at various partial stages downstream of the digital chirp generator elements $18_1$ to $18_4$.

Referring now to the form of the digital chirp generator elements, a normal digital chirp generator with its frequency and phase registers initialised to f and p respectively will generate the following sequence of phase values:-

| Time | Frequency | Phase |
|------|-----------|-------|
| 0 | $f$ | $p$ |
| 1 | $f+r$ | $p+f$ |
| 2 | $f+2r$ | $p+2f+r$ |
| 3 | $f+3r$ | $p+3f+3r$ |
| 4 | $f+4r$ | $p+4f+6r$ |
| $\vdots$ | | |
| n | $f+nr$ | $p+nf+\dfrac{n(n-1)}{2}r$ |
| n+1 | $f+(n+1)r$ | $p+(n+1)f+\dfrac{(n+1)n}{2}r$ |

Where $r$ is the ramp rate or frequency increment fed into the frequency accumulator, $f$ is the initial frequency value and $p$ the initial phase value.

If there are m parallel chirp general elements then the first one will have to generate every mth phase value i.e.

| Time | Interleaved Sample No | Frequency | Phase |
|------|----------------------|-----------|-------|
| 0 | 0 | $f$ | $p$ |
| 1 | m | $f+mr$ | $p+mf+\dfrac{m(m-1)}{2}r$ |
| 2 | 2m | $f+2mr$ | $p+2mf+\dfrac{2m(2m-1)}{2}r$ |
| $\vdots$ | | | |
| n | nm | $f+nmr$ | $p+nmf+\dfrac{nm(nm-1)}{2}r$ |

The second chirp generator element will have to generate every mth value starting at the second phase value i.e.

| Time | Interleaved Sample No | Frequency | Phase |
|------|----------------------|-----------|-------|
| 0 | 1 | $f+r$ | $p+f$ |
| 1 | m+1 | $f+(m+1)r$ | $p+(m+1)f+\dfrac{(m+1)m}{2}r$ |
| 2 | 2m+1 | $f+(2m+1)r$ | $p+(2m+1)f+\dfrac{(2m+1)2m}{2}r$ |

(continued)

| Time | Interleaved Sample No | Frequency | Phase |
|------|----------------------|-----------|-------|
| : | | | |
| n | nm+1 | f+(nm+1)r | $p+(nm+1)f+\frac{(nm+1)nm}{2}r$ |

In general the Kth chirp generator element (where K≤m) will have the following phase values

| Time | Interleaved Sample No | Frequency | Phase |
|------|----------------------|-----------|-------|
| n | nm + K - 1 | f+(nm+K-r | $p+(nm+K-1)f+\frac{(nm+K-1)\ (nm+K-2)}{2}r$ |

The Kth chirp generator element must produce phase samples which start at the Kth phase sample and are spaced m samples apart.

Now the next sample that the Kth chirp generator element will have to generate is at time n+1.

The frequency value is then

$$f(n+1,K,m) = f+((n+1)m+K-1)r$$

$$= f+(nm+K-1)r+mr$$

$$= f(n,K,m)+mr$$

So the frequency value for the Kth chirp generator element at time n+1 is m times the ramp rate *(r)* added to the previous frequency value of the Kth chirp generator.

The phase value of the Kth chirp generator element at time n+1 is given by

$$p(n+1,K,m)=p+((n+1)m+K-1)f+\frac{((n+1)m+K-1)\ ((n+1)m+K-2)}{2}r$$

$$=p+(nm+K-1)f+mf+[(nm+K-1)\ (nm+K-2)+m(nm+K-2)+m(nm+K-1)+m^2]\frac{r}{2}$$

$$=p+(nm+K-1)f+[(nm+K-1)\ (nm+K-2)]\frac{r}{2}+mf+(nm+K-1)r.m+(m-1)m.\frac{r}{2}$$

$$=p(n,K,m)+m[f+(nm+K-1)]+(m-1)m.\frac{r}{2}$$

$$=p(n,K,m)+m.f(n,K,m)+(m-1)m.\frac{r}{2}$$

So the phase value for the Kth chirp generator element at time n+1 is m(m-1)/2 times the ramp rate plus m times the previous frequency value of the Kth chirp generator element plus the previous phase value of the Kth chirp generator element.

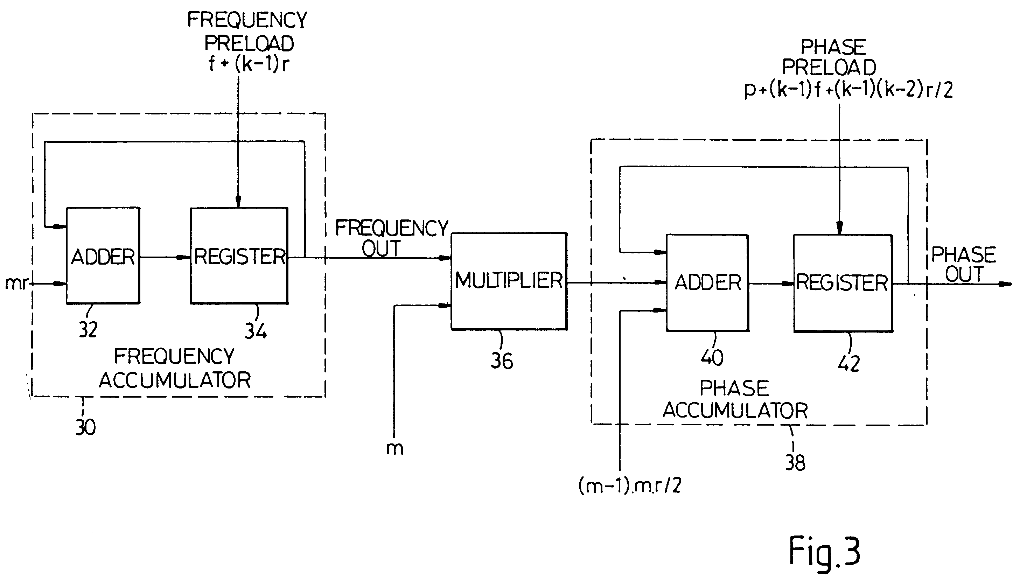

The digital chirp generator elements $18_1$ to $18_4$ may be constructed as shown in Figure 3. They each comprise a frequency accumulator 30 made up from an adder 32 plus a register 34, a times m multiplier 36 (or equivalent shift function if m is a power of two) and a phase accumulator 38 made up from an adder 40 plus a register 42. The frequency accumulator 30 is fed with m times the required ramp rate (mr). The output of the frequency accumulator 30 is multiplied by m and passed to the phase accumulator 38, where it is added to the previous phase value and to an extra term m (m-1)r/2.

When initialising a chirp generator element $18_K$, the frequency accumulator 30 is preloaded with f+(K-1)r and the phase accumulator 38 with p+(K-1)f+(K-1)(K-2)r/2.

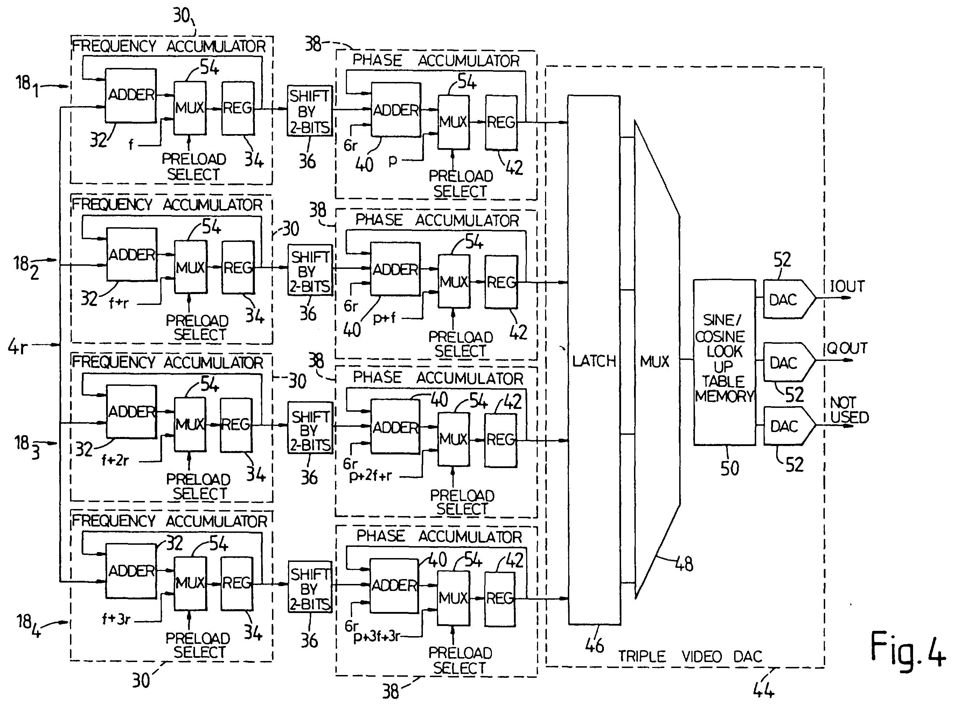

Referring now to Figure 4, an example of a parallel digital chirp generator comprising four parallel digital chirp generator elements $18_1$ to $18_4$ will be described, to indicate the appropriate preload values for the frequency and phase accumulations.

A parallel input triple video DAC device 44 is used, in this example, to provide the interleaving circuit 20, sine/cosine look-up tables and DACs. The video DAC contains a latch 46 and multiplexer 48, which implements the required sample interleaving, a 256 x 24-bit colour look-up table memory 50 which may be used to implement the required sine/cosine look-up table, and three DACs 52. The look-up table 50 is implemented in random access memory (RAM) and must be programmed with the required transfer function during system initialisation. The 24-bit output of the look-up table feeds three parallel DACs 52. Only two of these DACs are used in this example, one for the sine output and one for the cosine output.

A master clock (not shown) is used to clock all the registers in the parallel chirp generator at the same time and to simultaneously transfer data from the four phase outputs into the input of the triple video DAC 44.

All four parallel digital chirp generator elements $18_1$ to $18_4$ are fed with four times the required ramp rate (4r). The output of the frequency accumulator 30 is multiplied by four by shifting its output up by two bits (a simple wiring operation). The extra input to the phase accumulator 38 is six times the required ramp rate (6r).

The frequency and phase accumulators 30, 38 of each of the four digital chirp generator elements $18_1$ to $18_4$ are initialised with appropriate values as shown in Figure 4. Input multiplexers 54 are placed between the adder 32, 40 and the register 34, 42 in both the frequency and phase accumulators 30, 38. These multiplexers select the required preload value when a PRELOAD SELECT signal is asserted. Then on the next clock pulse the required preload values are clocked into the frequency and phase registers. A different pair of initialisation values are required for each digital chirp generator element.

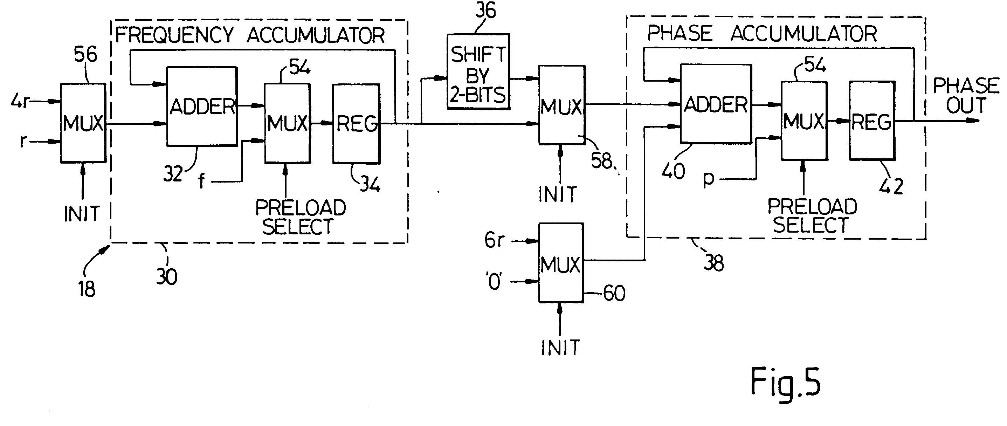

Referring to Figure 5, an alternative approach to initialising the four parallel digital chirp generators $18_1$ to $18_4$ is to load all of them with the required starting frequency, f, and starting phase, p. The four times frequency increment (4r) to the frequency accumulator 30 is replaced by the frequency increment (r) using a multiplexer 56. The times four multiplier 36 after the frequency accumulator 30 and the extra input (6r) to the phase adder 40 are disabled by respective multiplexers 58 and 60. The first parallel chirp generator $18_1$ is already initialised - it contains f in the frequency accumulator and p in the phase accumulator. The second chirp generator $18_2$ is given one clock pulse to initialise it, (giving f+r in frequency accumulation and p+f in phase accumulator); the third parallel chirp generator $18_3$ is given two clock pulses (giving f+2r in frequency accumulation and p+2f+r in phase accumulation), and the fourth one $18_4$ is given three clock pulses (giving f+3r in frequency accumulation and p+3f+3r in phase accumulation. This results in all four parallel chirp generators $18_1$ to $18_4$ being correctly initialised. The multiplexers 54, 56 and 58 are switched so that the active configuration of Figure 4 is now resumed and parallel chirp generation may begin.

## Claims

1. A digital chirp generator system including:

   a plurality of digital chirp generator elements ($18_1...18_n$) each comprising a frequency accumulator (30) including an input port and an output port, a multiplier or shifter (36) including an input port coupled to the output port of the frequency accumulator and an output port coupled to an input port of a phase accumulator (38), each of said digital chirp generator elements being operable to produce at the respective output ports of said phase accumulators (38) a plurality of phase samples, and means for interleaving said phase samples with phase samples from the or each other digital chirp generator elements ($18_1...18_n$) to provide a sequence of phase samples representing a chirp signal.

2. A digital chirp generator system according to Claim 1 which includes an interleaving circuit (20), sine/cosine look-up tables (22,24) and digital to analogue converters (26,28).

3. A digital chirp generator according to Claim 2, wherein the interleaving circuit (20) is before the sine/cosine look-up tables (22,24).

4. A digital chirp generator according to Claim 2, wherein the interleaving circuit (20) is after the sine/cosine look-up tables (22,24) and prior to the digital to analogue converters (26,28).

5. A digital chirp generator according to Claim 2, wherein the interleaving circuit (20) is after the digital to analogue converters (26,28).

6. A digital chirp generator according to Claim 2, wherein the interleaving circuit (20) is distributed, partly prior to the sine/cosine look-up tables (22,24), partly prior to the digital to analogue converters (26,28) and partly after the digital to analogue converters (26,28).

7. A digital chirp generator system according to any preceding Claim, including means for supplying to an input port of the frequency accumulator (30) an increment value **m.r,** means for supplying to an input port of said phase accumulator (38) a value **(m-1).m.r/2,** and wherein said multiplier or shifter (36) multiplies the value presented to the input port of the multiplier or shifter (36) by **m,** wherein **m** is the number of digital chirp generator elements in said plurality and **r** is the ramp rate or frequency increment.

8. A digital chirp generator according to any preceding Claim, including means for initialising the phase and frequency accumulators (30,38) with appropriate values.

9. A digital chirp generator according to any preceding Claim, operable to be placed in an initialisation configuration, and including means for loading the phase and frequency accumulators (30,38) of the digital chirp generator elements ($18_1...18_n$) with an initial value and means for then selectively clocking said accumulators (30,38) to provide the required start frequency and start phase values for each digital chirp generator element ($18_1 ... 18_n$).

10. A digital chirp generator according to Claim 8 or Claim 9, wherein said initialisation values comprise, for the $k^{th}$ digital chirp generator element, a value of **f+(k-1)r** for the frequency accumulator (30) and a value of **p+(k-1)f+(k-1)(k-2)r/2** for the phase accumulator, wherein **p** and **f** are the initial phase and frequency values respectively, and **r** is the ramp rate or frequency increment.

**Patentansprüche**

1. Ein digitales Pulskompressionsgeneratorsystem mit: einer Vielzahl von digitalen Pulskompressionsgeneratorelementen ($18_1...18_n$) mit jeweils einem Frequenzakkumulator (30), der ein Eingangstor und ein Ausgangstor umfaßt, einem Multiplizierer oder Schieber (36), der ein Eingangstor, das an das Ausgangstor des Frequenzakkumulators gekoppelt ist, und ein Ausgangstor, das an das Eingangstor eines Phasenakkumulators (38) gekoppelt ist, umfaßt, wobei jedes der digitalen Pulskompressionsgeneratorelemente betreibbar ist, um an den jeweiligen Ausgangstoren der Phasenakkumulatoren (38) eine Vielzahl von Phasenabtastungen zu produzieren, und Mitteln zum Verschachteln der Phasenabtastungen mit Phasenabtastungen von dem oder jedem anderen digitalen Pulskompressionsgeneratorelement ($18_1...18_n$), um eine Sequenz von Phasenabtastungen zu liefern, die ein Pulskompressionssignal darstellt.

2. Ein digitales Pulskompressionsgeneratorsystem nach Anspruch 1, welches einen Verschachtelungsschaltkreis (20), Sinus/Cosinus-Nachschlagtabellen (22, 24) und Digital/Analog-Wandler (26, 28) umfaßt.

3. Ein digitaler Pulskompressionsgenerator nach Anspruch 2, worin der Verschachtelungsschaltkreis (20) sich vor den Sinus/Cosinus-Nachschlagtabellen (22, 24) befindet.

4. Ein digitaler Pulskompressionsgenerator nach Anspruch 2, worin der Verschachtelungsschaltkreis (20) sich hinter den Sinus/Cosinus-Nachschlagtabellen (22, 24) und vor den Digital/Analog-Wandlern (26, 28) befindet.

5. Ein digitaler Pulskompressionsgenerator nach Anspruch 2, worin der Verschachtelungsschaltkreis (20) sich hinter den Digital/Analog-Wandlern (26, 28) befindet.

6. Ein digitaler Pulskompressionsgenerator nach Anspruch 2, worin der Verschachtelungsschaltkreis (20) teilweise vor den Sinus/Cosinus-Nachschlagtabellen (22, 24), teilweise vor den Digital/Analog-Wandlern (26, 28) und teilweise hinter den Digital/Analog-Wandlern (26, 28) verteilt ist.

7. Ein digitales Pulskompressionsgeneratorsystem nach einem vorhergehenden Anspruch mit Mitteln zum Zuführen eines Inkrementwerts **m.r** zu einem Eingangstor des Frequenzakkumulators (30), Mitteln zum Zuführen eines Werts **(m-1),m,r/2** zu einem Eingangstor des Phasenakkumulators (38), und worin der Multiplizierer oder Schieber (36) den Wert mit **m** multipliziert, der dem Eingangstor des Multiplizierers oder Schiebers (36) präsentiert wird, worin **m** die Anzahl von digitalen Pulskompressionsgeneratorelementen in der Vielzahl und **r** die Rampenrate oder das Frequenzinkrement ist.

8. Ein digitaler Pulskompressionsgenerator nach einem vorhergehenden Anspruch mit Mitteln zum Initialisieren der Phasen- und Frequenzakkumulatoren (30, 38) mit geeigneten Werten.

9. Ein digitaler Pulskompressionsgenerator nach einem vorhergehenden Anspruch, der betreibbar ist, um in einer Initialisierungskonfiguration angeordnet zu werden, und Mittel zum Laden der Phasen- und Frequenzakkumulatoren (30, 38) der digitalen Pulskompressionsgeneratorelemente ($18_1...18_n$) mit einem Anfangswert und Mittel umfaßt, um dann die Akkumulatoren (30, 38) selektiv zu takten, um die erforderlichen Startfrequenz- und Startphasenwerte für jedes digitale Pulskompressionsgeneratorelement ($18_1...18_n$) zu liefern.

**10.** Ein digitaler Pulskompressionsgenerator nach Anspruch 8 oder Anspruch 9, worin die Initialisierungswerte für das **k**-te digitale Pulskompressionsgeneratorelement einen Wert von **f+(k-1)r** für den Frequenzakkumulator (30) und einen Wert von **p+(k-1)f+(k-1)(k-2)r/2** für den Phasenakkumulator umfassen, worin **p** und **f** die Anfangsphasen- bzw. -frequenzwerte und **r** die Rampenrate oder das Frequenzinkrement sind.

**Revendications**

1.  Système numérique générateur d'impulsions modulées en fréquence, comprenant:

    -   une pluralité d'éléments de générateur numérique d'impulsions modulées en fréquence ($18_1$, ..., $18_n$) comprenant chacun un accumulateur de fréquence (30) comportant un accès d'entrée et un accès de sortie, un multiplieur ou un décaleur (36) comportant un accès d'entrée couplé à l'accès de sortie de l'accumulateur de fréquence, et un accès de sortie couplé à un accès d'entrée d'un accumulateur de phase (38), chacun desdits éléments de générateur numérique d'impulsions modulées en fréquence étant actionnable pour produire aux accès de sortie respectifs desdits accumulateurs de phase (38) une pluralité d'échantillons de phase, et des moyens pour entrelacer lesdits échantillons de phase avec des échantillons de phase issus du ou de chaque élément de générateur numérique d'impulsions modulées en fréquence ($18_1$ à $18_n$) pour fournir une suite d'échantillons de phase représentant un signal constitué par une impulsion modulée en fréquence.

2.  Système numérique générateur d'impulsions modulées en fréquence selon la revendication 1, qui comprend un circuit d'entrelacement (20), des tables de données sinus/cosinus (22, 24) et des convertisseurs numérique/analogique (26, 28).

3.  Générateur numérique d'impulsions modulées en fréquence selon la revendication 2, dans lequel le circuit d'entrelacement (20) est placé avant les tables de données sinus/cosinus (22, 24).

4.  Générateur numérique d'impulsons modulées en fréquence selon la revendication 2, dans lequel le circuit d'entrelacement (20) est placé après les tables de données sinus/cosinus (22, 24) et avant les convertisseurs numérique/analogique (26, 28).

5.  Générateur numérique d'impulsions modulées en fréquence selon la revendication 2, dans lequel le circuit d'entrelacement est placé après les convertisseurs numérique/analogique (26, 28).

6.  Générateur numérique d'impulsions modulées en fréquence selon la revendication 2, dans lequel le circuit d'entrelacement (20) est réparti, en partie avant les tables de données sinus/cosinus (22, 24), en partie avant les convertisseurs numérique/analogique (26, 28) et en partie après les convertisseurs numérique/analogique (26, 28).

7.  Système générateur d'impulsions modulées en fréquence selon l'une quelconque des revendications précédentes, comprenant des moyens pour fournir à un accès d'entrée de l'accumulateur de fréquence (30) une valeur d'incrément m·r, des moyens pour fournir à un accès d'entrée dudit accumulateur de phase (38) une valeur (m-1)m·r/2, et dans lequel ledit multiplieur ou décaleur (36) multiplie la valeur présentée à l'accès d'entrée du multiplieur ou décaleur (36) par m, où m est le nombre d'éléments de générateur numérique d'impulsions modulées en fréquence dans ladite pluralité d'éléments et r est le taux de rampe, ou incrément de fréquence.

8.  Générateur numérique d'impulsions modulées en fréquence selon l'une quelconque des revendications précédentes, comprenant des moyens pour initialiser les accumulateurs de phase et de fréquence (30, 38) avec des valeurs appropriées.

9.  Générateur numérique d'impulsions modulées en fréquence selon l'une quelconque des revendications précédentes, actionnable pour être mis dans une configuration d'initialisation et comprenant des moyens pour charger les accumulateurs de phase et de fréquence (30, 38) des éléments de générateur numérique d'impulsions modulées en fréquence ($18_1$ à $18_n$) avec une valeur initiale, et des moyens pour cadencer ensuite sélectivement lesdits accumulateurs (30, 38) pour fournir les valeurs de la fréquence de début et de la phase de début pour chaque élément de générateur numérique d'impulsions modulées en fréquence ($18_1$, ..., $18_n$).

10. Générateur numérique d'impulsions modulées en fréquence selon la revendication 8 ou la revendication 9, dans lequel lesdites valeurs d'initialisation comprennent, pour le k-ième élément de générateur numérique d'impulsions modulées en fréquence, une valeur de f+(k-1)r pour l'accumulateur de fréquence (30) et une valeur de p+(k-1)f+(k-1)(k-2)r/2 pour l'accumulateur de phase, dans lesquelles p et f sont les valeurs initiales de phase et de fréquence, respectivement, et r est le taux de rampe, ou incrément de fréquence.

Digital Chirp Generator Block Diagram

Fig.1

Fig.2

EP 0 528 565 B1

Fig.3

FREQUENCY
PRELOAD
f + (k−1)r

PHASE
PRELOAD
p+(k−1)f +(k−1)(k−2)r/2

ADDER · 32    REGISTER · 34

FREQUENCY
ACCUMULATOR · 30

mr

FREQUENCY
OUT

MULTIPLIER · 36

m

ADDER · 40    REGISTER · 42

PHASE
ACCUMULATOR · 38

PHASE
OUT

(m−1).m.r/2

EP 0 528 565 B1

Fig.4

EP 0 528 565 B1

Fig.5

13